Europäisches Patentamt

European Patent Office

Office européen des brevets

(19)

(11) Publication number: **0 128 971**
A1

# (12) EUROPEAN PATENT APPLICATION

(21) Application number: 83106029.8

(22) Date of filing: 21.06.83

(51) Int. Cl.³: **F 16 F 15/06**
F 16 F 15/03, H 01 J 37/02

(43) Date of publication of application:
27.12.84 Bulletin 84/52

(84) Designated Contracting States:
CH DE FR GB LI

(71) Applicant: International Business Machines Corporation
Old Orchard Road
Armonk, N.Y. 10504(US)

(72) Inventor: Binnig, Gerd Karl
Reidholzstrasse 41
CH-8805 Richterswil(CH)

(72) Inventor: Gerber, Christoph Emanuel
Sonnenbergstrasse 47
CH-8134 Adliswil(CH)

(72) Inventor: Ott, Hanspeter
Alte Landstrasse 22
CH-8800 Thalwil(CH)

(72) Inventor: Rohrer, Heinrich
Bachtelstrasse 27
CH-Richterswil(CH)

(72) Inventor: Weibel, Ernst
Zelgstrasse 46
CH-8134 Adliswil(CH)

(74) Representative: Rudack, Günter O., Dipl.-Ing.
Säumerstrasse 4
CH-8803 Rüschlikon(CH)

(54) Vibration filter.

(57) The vibration filter employes a plurality of spiral springs (30, 31; 34, 35; 39, 40) arranged between a rigid bench (29) and a table (41) which carries apparatus to be vibration-protected. The springs are attached to links (32, 33; 37, 38) which may be provided with interconnections to enhance horizontal stability. If more than one stage is intended, the masses of the intermediate frames (36) and the spring characteristics are chosen such that each stage has a resonant frequency sufficiently different from that of any other stage.

Additional vibration damping is achieved through shortened induction coils or copper blocks (46, 47) diving into the magnetic field of appropriately located permanent magnets (48, 49).

FIG. 4

EP 0 128 971 A1

VIBRATION FILTER

The invention relates to a vibration filter which is capable of serving as a support for apparatus having to be protected against such minute residual vibrations that have an amplitude on the order of $10^{-11}$m. An example for such sensitive apparatus is the well-known Scanning Tunneling Microscope in which an extremely fine point is scanned across a surface at always constant distance, with the control current required to keep the distance to about $10^{-9}$m serving to depict a profile of the surface scanned.

Essentially, there are two sources of undesired vibrations which must be eliminated lest the apparatus should be damaged or the measurements become incorrect. One sort of vibrations is transferred to the apparatus by the waves of sound. Elimination of sound waves is most easily done by placing the entire apparatus into a vacuum chamber. Where use of vacuum is not possible, i.e. where investigations are to be made at ambient pressure or with the tunneling area immersed in a droplet of liquid, as for biological investigations, for example, the apparatus must be enclosed in a sound-proof and echo-free hood.

The second type of vibrations stems from mechanical concussions in the environment propagated through body-contact to the apparatus. It is this type of vibrations that the present invention seeks to attenuate below the level of noticeability by the apparatus supported by the vibration filter to be described below.

Vibration filters known to date in the art are of two types, namely those relying on a comparatively large mass which accordingly has a high resistance against vibration as well as a low resonance frequency. Filters of this type are mainly used as supports for high-precision balances and as benches for optical apparatus, for example. The second type of vibration filter uses elastic elements to absorb ambient vibrations, namely rubber blocks and springs. Applications for the second type of filter are in the suspension of vibrating engines, as in motor cars, and in high-fidelity turntables.

Except perhaps for the high-precision balances mentioned above, vibration damping known in the art has generally to do with vibrations of an amplitude in the $10^{-6}$m range, and even for record players the attenuation desired does not go beyond $10^{-8}$m. Yet modern surface physics investigates objects of atomic size, and the instruments used in these investigations have to be protected from vibrations on the order of atomic magnitude so as not to jeopardize inspection and measurement of those objects.

The present invention relates to the second type of vibration filter in that it relies on a special arrangement of springs. A very efficient vibration filter has been described in European Patent Publication (Patent Application 81 107 380.6) in which a two-stage mass-and-spring arrangement is shown to employ coil springs hanging from gibbets and supporting the apparatus to be protected. While this prior art arrangement meets all requirements from a vibration protection point of view, it has the disadvantage of the gibbet/spring assemblies impeding access to the apparatus supported and of requiring lots of space, particularly because the springs elongate under load.

0128971

These disadvantages can be overcome by a vibration filter employing spiral springs instead of coil springs. A resilient mounting using planar spiral springs is tought by British Patent No. 686,514. The spiral springs are fixed to a base with their outer ends, and the supported apparatus is linked to their inner ends, with the plane of the springs always being upright. While this arrangement apparently very well eliminates vertical movements of the base on which it rests, it shows great instability in horizontal direction, particularly for low-frequency vibrations occuring with forces in a direction essentially perpendicular to the plane of the springs.

It is a purpose of the present invention to eliminate all of the shortcomings of the prior art and to propose a vibration filter which has the desired mechanical properties and which does not enlarge under normal use conditions. Accordingly, the invention concerns a vibration filter for supporting vibration-sensitive apparatus comprising an at least one-stage spring/mass arrangement suspended from a rigid base plate, the springs being of the spiral type. The vibration filter is characterized in that at least three spiral springs with their axes vertical are with one end rigidly fixed on said base plate, and with their other end fixed to the mass on which the vibration-sensitive apparatus is supported, with the mass and the spring characteristics chosen such that the attenuation of vibrations is greatest at low frequencies.

Details of preferred embodiments of the invention will hereafter be described by way of example, with reference to the drawings, in which:

Fig. 1       is a perspective view of a vibration filter
             with four legs;

Fig. 2       shows a volute spring of upright rectangular band metal;

Fig. 3       is a two-stage vibration filter employing
             normally conical spiral springs;

Fig. 4       is a two-stage vibration filter with two
             frames and eddy current damping.

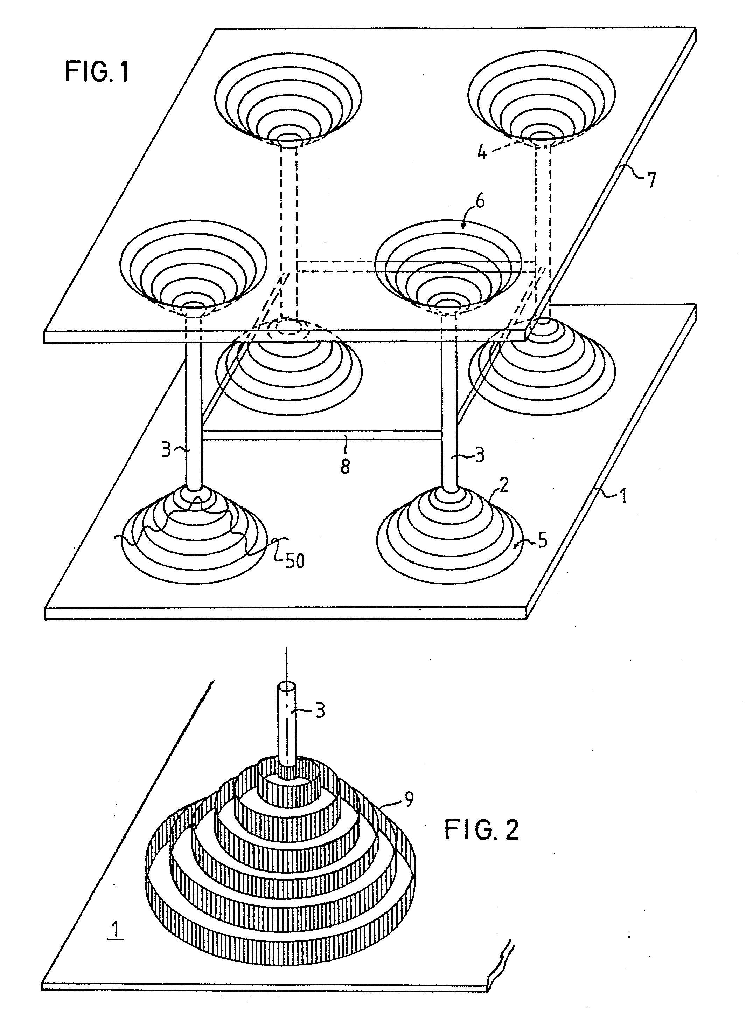

Referring to Fig. 1, the vibration filter comprises a base plate 1 which carries the appropriate number of legs, e.g. four, each consisting of a lower conical spiral spring 2, a vertical link 3 and an upper conical spiral spring 4. The connection between link 3 and each one of springs 2 and 4 is absolutely rigid. The springs 2 and 4 are preferably arranged inside corresponding openings 5 and 6, respectively, in base plate 1 and in a support plate 7 in order to provide for free vertical movement of the springs, even in case of slight overload. Under no-load conditions, springs 2 and 4 of each leg assume a conical shape. When loaded, the springs become compressed so that all of their windings are essentially located in a common plane. Accordingly, under normal load conditions, the filter needs less space than unloaded.

It has been found that the desired degree of stability in horizontal direction of the filter arrangement requires connections between the legs. Horizontal bars 8 are rigidly fixed to vertical links 3 of neighbouring legs so as to create a stiff frame. By the same token, instead of bars 8, resilient means such as springs may be used. It is advantageous to extend the springs from the top of one link 3 to the bottom of its neighbours.

While the filter arrangement of Fig. 1 is contemplated with springs made of wire with circular cross section, additional horizontal stiffness may be achieved with springs of the volute type, i.e. formed of a conical spiral coil of upright metal band 9 as shown in Fig. 2. Of course, the wider the band, the greater the horizontal stiffness of the filter. Special care has to be taken that the windings never touch lest internal friction should occur which may be the cause of vibrations. With a volute spring, the horizontal stiffness may be sufficient even without the frame composed of bars 8.

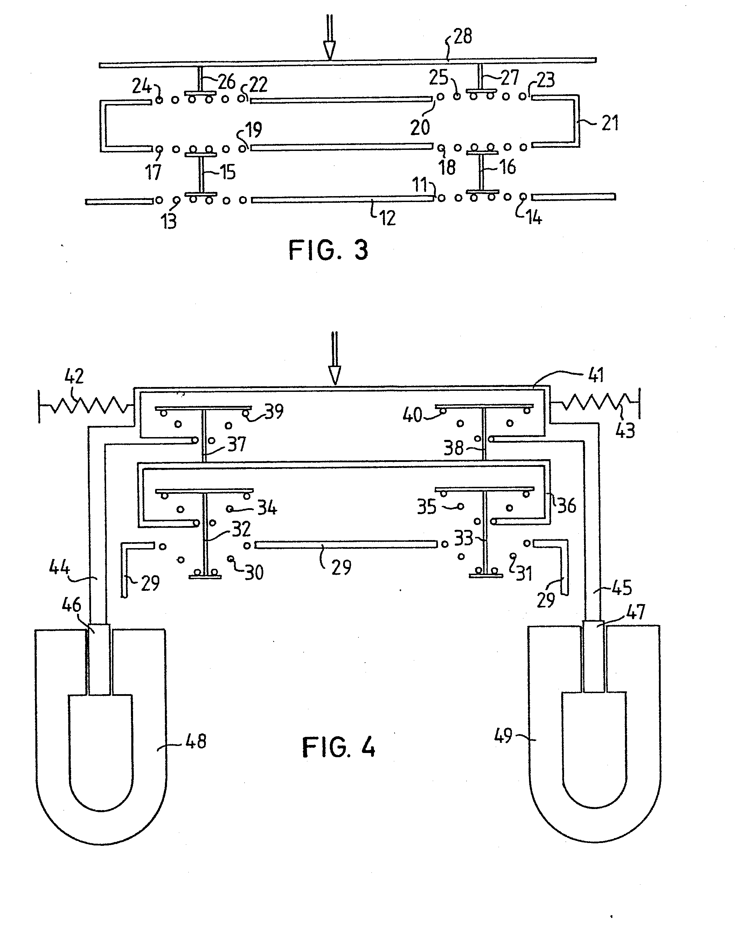

The efficiency of the filter can be increased by providing a two-stage arrangement as shown in Fig. 3. In openings 10 and 11 of base plate 12 are arranged spiral springs 13 and 14. To the center windings of springs 13 and 14 are attached links 15 and 16 which support the center windings of spiral springs 17 and 18 the outer windings of which are mounted in a first set of openings 19 and 20 of a frame 21. In a second set of openings 22 and 23 in frame 21 are arranged springs 24 and 25 which on their center windings carry links 26 and 27 which support a table 28.

In this embodiment the springs are designed so that under the arrangement's own weight all of the springs become pre-loaded and assume a position in which all windings of each individual spring locate themselves in a common plane, as shown in Fig. 3. Loading table 28 with the load for which the vibration filter was designed will result in a flexing of all springs thereby reducing the height of the filter.

Fig. 4 shows a similar arrangement, however with two frames. The figure is drawn to illustrate the position the springs will assume when the filter carries the load for which it was designed. Attached to base plate 29 are spiral springs 30 and 31 which carry links 32 and 33, respectively. The latter are connected to the outer windings of springs 34 and 35, respectively, the inner windings of which are attached to a first frame 36. Fixed to frame 36 are links 37 and 38 which carry the outer windings of springs 39 and 40, the inner windings of which are attached to a second frame 41. The load is carried on top of frame 41.

As mentioned before, Fig. 4 illustrates the filter in its loaded state. If the load is removed, the springs will resume a condition where all windings lie in the same plane under the influence of the weight of the parts of the filter themselves. Accordingly, under load the filter will occupy less space than in its unloaded state.

In the case of a filter with more than one stage, the characteristics of the springs in any one stage should be chosen to be sufficiently different from those of the other stages so as to eliminate the possibility of propagating eigen-frequency oscillations.

While Figures 1, 3 and 4 show filter arrangements with four legs or equivalent arrangements requiring four springs in each set, a three-spring arrangement would certainly offer improved stability in horizontal direction. Still another way of improving horizontal stability is the provision of lateral springs, such as springs 42 and 43 in Fig. 4.

To still further enhance the vibration extinction efficiency of the filter arrangement, electromagnetic or eddy current damping may be provided. Rigidly mounted on frame 41 are bars 44 and 45 (Fig. 4) which extend downward from the upper surface, and which attach to an induction coil 46 and 47, respectively. Each induction coil is shortened via a resistance (not shown) and dives into the magnetic field between the poles of a horse-shoe magnet 48, 49. The reason for having horse-shoe magnets and for arranging them away from the area where the load, i.e. some measuring or manufacturing apparatus, is supported, is of course the desired reduction of influence from magnetic stray fields. As will be clear to those skilled in the art, the induction coils 46 and 47 can be replaced by solid copper blocks to provide for eddy current damping.

In both cases of electromagnetic and eddy current damping, the arrangement of Fig. 4 is only effective against vibrations in vertical direction. If damping of other components is desired, additional magnet and coil/copper block arrangements are required with appropriate alignment of the magnets.

While the damping measures so far described are particularly effective against low-frequency vibrations, it has turned out to be advisable to interweave the windings of the springs of the filter with resilient filaments or ribbon 50 to provide for additional attenuation of high-frequency components in the vibrations and to absorb the energy introduced into the filter (Fig. 1).

## C L A I M S

1.    Vibration filter for supporting vibration sensitive apparatus, comprising an at least one-stage spring/mass arrangement suspended from a rigid base plate, the springs being of the spiral type, characterized in that at least three spiral springs (2, 4; 13, 14; 17, 18; 24, 25; 30, 31; 34, 35; 39, 40) with their axes vertical are with one end rigidly fixed on said base plate (1, 12, 29), and with their other end fixed to the mass (7, 28, 41) on which the vibration-sensitive apparatus is supported, with the mass and the spring characteristics chosen such that the attenuation of vibrations is greatest at low frequencies.

2.    Vibration filter according to claim 1, characterized in that in a one-stage arrangement two spiral springs (2, 4) with their windings closest to the spring axis are joined by a link (3) and with their windings farest from the spring axis are mounted respectively to said base plate (1) and to said mass (7) on which the vibration-sensitive apparatus is supported.

3.    Vibration filter according to claim 1, characterized in that in a two-stage arrangement said mass (28, 41) on which the vibration sensitive apparatus is supported is suspended by a first set of legs each comprising a spring (24, 25; 39, 40) and a link (26, 27; 37, 38), the legs being supported on one face of an intermediate frame (21, 36) and carrying said mass (28, 41), the frame (21, 36) in turn being supported from said base plate (12, 29) by means of a second set of legs each comprising two spiral springs (13, 17; 14, 18; 30, 31; 34, 35) and a link (15, 16; 32, 33).

4.     Vibration filter according to claim 2 or 3, characterized in that the spiral springs (2, 4; 24, 25) in their unloaded state have all of their windings occupying a common plane.

5.     Vibration filter according to claim 2 or 3, characterized in that the spiral springs (2, 4; 24, 25) are of the volute type and in their unloaded state have a conical shape.

6.     Vibration filter according to claim 3, characterized in that the springs belonging to different sets of legs have different spring characteristics such that the resulting resonant frequencies differ from stage to stage.

7.     Vibration filter according to claim 1, characterized in that the legs are interconnected by horizontal bars (8) attached to said links (3).

8.     Vibration filter according to claim 1 or 3, characterized in that said mass (1, 28) and/or an intermediate frame (21) is connected to a damping spring (42, 43) which is in turn attached to a rigid mount.

9.     Vibration filter according to claim 1, characterized in that said mass (41) has bars (45, 46) each carrying a copper block (46, 47) which is aligned between the poles of a permanent magnet (48, 49).

10.    Vibration filter according to claim 1, characterized in that said mass has bars (45, 46) each carrying a shortened induction coil (46, 47) aligned between the poles of a permanent magnet (48, 49).

11. Vibration filter according to claim 1, characterized in that resilient filaments (50) are woven into part or all of said spiral springs (2, 4; etc.).

0128971

FIG.1

FIG. 2

9-83-001

FIG. 3

FIG. 4

9-83-001

European Patent
Office

EUROPEAN SEARCH REPORT

**0128971**
Application number

EP 83 10 6029

## DOCUMENTS CONSIDERED TO BE RELEVANT

| Category | Citation of document with indication. where appropriate, of relevant passages | Relevant to claim | CLASSIFICATION OF THE APPLICATION (Int. Cl. ³) |
|---|---|---|---|
| X | US-A-2 397 804 (NAKKEN)<br>* Page 1, left-hand column, lines 19-48; page 1, rigth-hand column, line 42 - page 2, right-hand column, line 30; figures 1-8 * | 1,5,8 | F 16 F 15/06<br>F 16 F 15/03<br>H 01 J 37/02 |
| X | GB-A- 458 342 (FRANCOIS CEMENTATION CIE.)<br>* Whole document * | 1,2 | |
| A | FR-A-2 082 170 (S.E.R.E.)<br>* Whole document * | 1,7 | |
| A | US-A-2 481 505 (FRAZIER)<br>* Column 2, line 26 - column 4, line 8; figures 1-3 * | 1,5,7 | |
| A | US-A-3 399 879 (HOJO)<br>* Column 1, lines 14-55; column 4, lines 60-75; figures 1-7 * | 1,2,6 | TECHNICAL FIELDS SEARCHED (Int. Cl. ³) |
| A | US-A-2 751 179 (ORAVEC)<br>* Whole document * | 4,5 | F 16 F<br>H 01 J<br>G 01 N<br>G 01 P<br>G 12 B |
| A | BE-A- 470 093 (BLOEM)<br>* Figure 4 * | 3 | |
| A | FR-A-2 415 751 (GAY)<br>* Whole document * | 9 | |
| | --- -/- | | |

The present search report has been drawn up for all claims

| Place of search<br>THE HAGUE | Date of completion of the search<br>19-03-1984 | Examiner<br>ESPEEL R.P. |
|---|---|---|

**0128971**

Application number

## European Patent Office

## EUROPEAN SEARCH REPORT

EP  83 10 6029

| | DOCUMENTS CONSIDERED TO BE RELEVANT | | Page  2 | |
|---|---|---|---|---|
| Category | Citation of document with indication. where appropriate, of relevant passages | Relevant to claim | | CLASSIFICATION OF THE APPLICATION (Int Cl ³) |
| A | DE-A-2 603 688  (IBM) <br> * Page  7, paragraph 3 - page 8, paragraph 3; figure 3 * | 10 | | |
| | --- | | | |
| A | FR-A-  635 416  (WESTINGHOUSE) <br> * Page 4; abstract; figures 1-7 * | 11 | | |
| | --- | | | |
| A | DE-B-2 540 594  (SIEMENS) | | | |
| | --- | | | |
| A | FR-A-2 143 292  (ASSOCIATED ELECTRICAL IND.) | | | |
| | --- | | | |
| A | US-A-2 581 416  (IREY) | | | |
| | --- | | | TECHNICAL FIELDS SEARCHED (Int. Cl. ³) |
| A | US-A-2 912 212  (LOWE) | | | |
| | --- | | | |
| A | US-A-1 751 261  (WILSON) | | | |
| | --- | | | |
| D,A | GB-A-  686 514  (BRITISH THOMSON HOUSTON) | | | |
| | --- | | | |
| D,A | EP-A-0 048 459  (H.H. HOND ROKKU) | | | |
| | ----- | | | |

The present search report has been drawn up for all claims

| Place of search | Date of completion of the search | Examiner |
|---|---|---|
| THE HAGUE | 19-03-1984 | ESPEEL R.F. |